(19) Europäisches Patentamt
European Patent Office
Office européen des brevets

(11) **EP 4 009 462 A1**

(12) **EUROPEAN PATENT APPLICATION**

(43) Date of publication:
**08.06.2022 Bulletin 2022/23**

(21) Application number: **20211327.0**

(22) Date of filing: **02.12.2020**

(51) International Patent Classification (IPC):
**H02J 3/00** *(2006.01)*      **G06N 3/02** *(2006.01)*
**H02J 13/00** *(2006.01)*

(52) Cooperative Patent Classification (CPC):
**H02J 3/0012; G06N 3/02; H02J 13/00002;**
H02J 2203/10; H02J 2203/20; H02J 2300/10

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Siemens Aktiengesellschaft
80333 München (DE)**

(72) Inventors:
• **Beyer, Dagmar
80339 München (DE)**
• **Henselmeyer, Sylwia
91052 Erlangen (DE)**
• **Hildebrandt, Marcel
80634 München (DE)**
• **Joblin, Mitchell
81825 München (DE)**
• **Ringsquandl, Martin
83022 Rosenheim (DE)**
• **Weber, Sebastian
90429 Nürnberg (DE)**

(54) **ASSISTANCE APPARATUS FOR LOCALIZING ERRORS IN A MONITORED TECHNICAL SYSTEM**

(57) Assistance apparatus for localizing errors in a monitored technical system (10) consisting of devices and/or transmission lines, comprising at least one processor configured to
- obtain values of actual attributes of the devices (11, 12) and/or of the transmission lines (13),
- determine an error probability for each device (11,12) and/or transmission line (13) by processing a graph neural network with the obtained actual values of attributes as input, wherein the graph neural network is trained by training attributes assigned to an attributed graph representation (26) of the technical system (10), and
- output an indication for such devices (11, 12) and/or transmission lines (13), whose error probability is higher than a predefined threshold.

FIG 2

EP 4 009 462 A1

**EP 4 009 462 A1**

## Description

The present disclosure relates to an assistance apparatus and a method for localizing errors in a monitored technical system consisting of devices and/or transmission lines.

In various technical fields, there is a need to monitor the operation and status of a technical system especially distribution networks like an electrical power grid for distribution of electrical current, a communication network, a distribution network for water, a transport network e.g. for railways. Monitoring of electrical power grids, especially on distribution level, becomes an increasingly difficult problem. E.g., in electrical power grids the grid operation becomes more volatile due to a wide proliferation of small-scale generator injections. So called "smart grids" provisioned to be able to predict disruptions and prevent the grid from critical system states, e.g. blackouts. On the other hand, more elements in the grid also lead to higher uncertainty about the static part of the system, i.e. more potential errors in the data describing the technical system.

State estimation is a technique to uncover hidden state information, e.g. main voltage magnitude and phase angles, using different kinds of measurements. However, measurements have inherent uncertainty and meta-information about measurements can also be error-prone, e.g. the location or type of the measurement are wrong.

Traditional distribution systems state estimation can deal to some extent with noisy measurements but assumes reliable static data and meta-information describing the power grid in terms of generators, loads, transmission lines, and their characteristics. However, for bigger infrastructures this is rarely the case. This general assumption made by traditional distribution systems state estimation methods make them particularly brittle and unfit for use in modern power grids.

Therefore, it is the object of the present application to localize errors in data of a technical system, e.g. static data errors like noisy measurements, topology errors or dynamic data errors like values of measurement or wrong meta-information. In case of correct measurements, it is the technical object to localize that component of the technical system which causes this measurement and therefore works in an abnormal manner.

This object is solved by the features of the independent claims. The dependent claims contain further developments of the invention.

The first aspect relates to an assistance apparatus for localising errors in a monitored technical system consisting of devices and/or transmission lines, comprising at least one processor configured to

- obtain values of actual attributes of the device and/or of the transmission lines,
- determine an error probability for each device and/or transmission line by processing a graph neural network with the obtained actual values of attributes as input, wherein the graph neural network is trained by training attributes assigned to an graph representation of the technical system, and
- output an indication for such devices and/or transmission lines, whose error probability is higher than a predefined threshold.

A graph representation to which attributes are assigned is further called attributed graph representation. The training attributes assigned to a graph representation of the technical system are preferably based on data of known and labelled similar technical systems. For training the graph neural network, attributes of all devices and transmission lines of the technical system have to be considered and provided by the attributed graph representation. On applying values of actual attributes by the assistance apparatus, it is possible to obtain only attributes of a subzone of the technical system, e.g. the subzone for which new measurements or new static attributes are available.

The technical system which can be monitored by the assistance apparatus can be any type of system consisting of devices and transmission lines which are interconnected and wherein any medium is transmitted in between. Topology and attributes of divers structured distribution network can be transferred into the flexible graph representation and processed by the flexible message passing to neighbouring devices and transmission lines of the graph neural network.

According to an embodiment the assistance apparatus is configured such that the attributed graph representation represents the typology of the technical system, wherein each device and each transmission line is represented by a node and each pair of nodes interacting with each other is connected by an edge, and wherein different types of devices and different types of transmission lines are represented by different types of nodes.

The attributed graph representation allows a detailed description of the interconnections of the different nodes and provides a basis for associating attributes with a specific node located in a specific location of an interconnected technical system of nodes.

According to an embodiment the assistance apparatus is configured such that the attributes assigned to the node comprises at least one of sensor data of a set of parameters measured at the node and static features of the node.

Therefore, it is possible to consider both attributes representing measurements of one or several specific parameters which characterise the node and which may dynamically change and also features of the node which have a static characteristic, e.g. length, material or impedance of the transmission line.

In a preferred embodiment the assistance apparatus is configured such that the graph neural network determines a vector representation of each node and forwards the determined vector representation of the node to the neighbouring nodes.

Preferably, the graph neural network is configured as a graph convolutional network comprising at least one convolutional layer. Such a graph convolutional neural network provides deep learning taking into account several kinds of attributes. In contrast to other neural networks a graph neural network and especially a graph convolutional network can generalise across different topologies due to its flexibility of message passing through nodes of any network.

In the preferred embodiment the assistance apparatus is configured such that the graph neural network is trained by the attributed graph representation comprising training attributes of at least one node operating in an abnormal mode.

Hence, the graph neural network is trained by node classification as training regime. This training regime is particularly advantageous because an abundance of training data can be generated from each error-free instance of the technical system. If the performance of the neural network is insufficient, additional training data can be generated by conceiving new perturbation mechanism that introduce additional error types. The respectively trained graph neural network can identify the error and additionally localize a subzone of the technical system or even dedicated node where the error occurred.

In a preferred embodiment the assistance apparatus is configured such that the graph neural network is trained by injecting attributes representing erroneous measurements of a predetermined node into the graph representation, wherein the attributes of all other nodes represent error-free measurements.

This allows to further isolate the node at which the error occurred, e.g. on a few nodes or one single node.

In a further preferred embodiment, the assistance apparatus is configured such that the injected attribute representing erroneous measurements is a measurement value of reverse algebraic sign with respect to an error-free measurement value of the attribute of the node.

This provides a uniform weighting of the errors of each node as the magnitude of each error correlates with the magnitude of the error-free value.

In a preferred embodiment the assistance apparatus is configured such that the trained graph neural network provides as an output a probability for the nodes either having an error or having no error.

The assistance apparatus therefore provides a binary classification such that for each node a 0 indicates no error and a 1 indicates an error.

According to an alternative embodiment the assistance apparatus is configured such that the graph neural network is trained by attributed graph representations comprising training attributes of the nodes representing all nodes operating in a normal mode.

This means that all static and dynamic attributes in the graph representation are assumed to origin from a error-free node and attributes are only underlying typical variations. Data of the technical system working in normal mode should be available in a large extent.

In a further embodiment the assistance apparatus is configured such that the graph neural network is trained by attributed graph representation comprising training attributes of the node representing all nodes operating in a normal mode.

In a further preferred environment are trained graph neural network provides as an output predicted values of the attributes of each node.

In a further embodiment the graph neural network is trained by minimizing a loss function between the training values of the attributes and predicted values of the attributes of each node, especially by minimizing a mean squared error function.

For a zone of the technical system having measurement values available the measurement values and the predicted values of the respective nodes are compared. Depending on the deviation between the two values, an error probability is calculated and compared to the threshold probability. The localized properties of the graph neural network are beneficial in that case since the influencing area of a predicted value is only in the local neighbourhood of the particular considered node, the searched space for an error is also restricted to this local neighbourhood.

In a preferred embodiment the assistance apparatus is configured such that the technical system is a technical distribution network, especially an electrical power grid.

In a further embodiment the assistance apparatus is configured such that different types of nodes of the graph representation represent different types of power generation devices, power switching devices, and/or power transmission lines and the edge between two nodes represent a potential flow of current.

The assistance apparatus is therefore preferably configured to localize errors in an electrical power grid especially for power grids where a wide proliferation of small-scaled generator injections occur and the grid operation becomes volatile.

A second aspect concerns a method for localizing errors in a monitored technical system of interconnected devices, comprising

- obtaining values of actual attributes of the devices and/or the transmission lines,
- determining an error probability for each device and/or transmission line by processing a graph neural network with the obtained actual values of attributes as input, wherein the graph neural network is trained by training attributes assigned to an attributed graph representation of the technical system, and
- outputting an indication for such devices and/or transmission lines whose error probability is higher than a predefined threshold.

A third aspect concerns a computer program product directly loadable into the internal memory of a digital computer, comprising software code portions for performing the steps as described before, when said product is run on said digital computer.

The invention will be explained in more detail by reference to accompanying figures. Similar objects will be marked by the same reference signs.

Figure 1     schematically illustrates an application scenario comprising an embodiment of the assistance apparatus.

Figure 2     schematically illustrates a detailed view on a prediction unit being part of the assistance apparatus according to an embodiment of the present disclosure.

Figure 3     illustrates a graph representation according to an embodiment of the present disclosure.

Figure 4     schematically illustrates a message passing for a 1-layer graph neural network according to an embodiment of the present disclosure.

Figure 5     schematically illustrates a message passing for a 2-layer graph neural network according to an embodiment of the present disclosure.

Figure 6     shows a flow chart for illustrating a method according to an embodiment of the present disclosure.

It is noted that in the following detailed description of embodiments, the accompanying drawings are only schematic, and the illustrated elements are not necessarily shown to scale. Rather, the drawings are intended to illustrate functions and the co-operation of components. Here, it is to be understood that any connection or coupling of functional blocks, devices, components or other physical or functional elements could also be implemented by an indirect connection or coupling, e.g., via one or more intermediate elements. A connection or a coupling of elements or components or nodes can for example be implemented by a wire-based, a wireless connection and/or a combination of a wire-based and a wireless connection. Functional blocks can be implemented by dedicated hardware, firmware or by software, and/or by a combination of dedicated hardware and firmware and software. It is further noted that each functional unit described for an apparatus can perform a functional step of the related method.

It is further noted that the phrase error and the phrase fault are used as synonyms throughout this document.

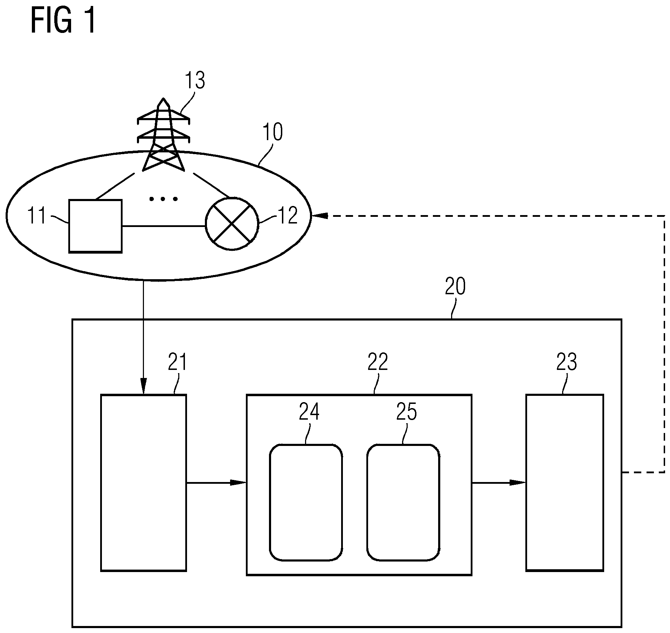

Figure 1 shows a technical system 10 comprising a variety of different devices 11, 12 and distribution line 13 which are interconnected. The technical system 10 can be any kind of distribution network, especially an electrical power grid, but it can also be an infrastructure network, for example a railroad network or a communication network, e.g. of an automation network. Monitoring such a technical system, especially on distribution level, becomes an increasingly difficult problem, especially in modern power grids, as grid operation becomes more volatile due to a wide proliferation of small-scaled generated injections. In so called smart grids it shall be possible to predict disruptions and to prevent the grid from critical system states, e.g. blackouts. Therefore, the state of the technical system as a whole or the state of sub-zones of the technical system have to be monitored and also estimated to unveil unrecognised errors in any of the devices or distribution lines as fast as possible.

State estimation is a technique to uncover hidden state information e.g. voltage magnitude and phase angles in a power grid, using different kinds of measurements. However, measurements have inherent uncertainty and meter information about measurements can also be error prone, e.g. a location or type of the measurement may be wrong. Traditional distribution system state estimation methods can deal to some extent with an error prone measurement but assume reliable static data and meter information describing a technical system in terms of the devices and transmission lines.

In the technical system 10 reliable information is required for devices 11, 12, 13 like generators, nodes, transmission lines and their characteristics. Errors in the static data propagate through power flow and state estimation calculations and lead to unreliable results. A main problem in the data of a technical system like a power grid are especially static data errors, e.g. wrong impedance of transmission lines or a wrong topology information. Also, dynamic data errors occur, e.g. wrong values of measurements, wrong location of the measurements which are often caused by wrong meter information to the measurement.

To localize such errors e.g. noisy measurements, typology errors or wrong measurement meta-information in underlying data of the technical system 10, various attributes of the devices and/or of the transmission lines 11, 12, 13 of the technical system 10 are obtained and processed by the assistance apparatus 20. The assistance apparatus 20 outputs an indication for such devices 11, 12 and/or transmission line 13, whose error probabilities is higher than a predefined threshold.

The assistance apparatus 20 consists of a data interface 21 which is configured to obtain the values of actual attributes. The assistance apparatus 20 further consists of a prediction unit 22 consisting of a graph representation generator 24 and a graph neural network unit 25. The graph representation generator 24 as well as the graph neural network unit 25 are functional units, whereas the function is performed by at least one processor processing a computer program product which is loadable into an internal memory of the assistance apparatus 20, not depicted, and which comprises software code portions for performing the respective method steps of this functional unit when the computer program product is run on said at least one processor.

The prediction unit 22 determines an error probability which relates to the probability of a device having errory or erroneous attributes and output via output interface 23. The determined error probability can also relate to a probability whether a predicted value of an attribute corresponds to a measured attribute which was obtained by the data interface 21 as actual attribute of the technical system 10. Based on the indication for such device an erroneous measurement, erroneous meter information of a measurement or erroneous data on static attributes of the technical system 10 can be localized and corrected in the distributed system state estimation model set up for the technical system 10. On the other hand, the indication of such an erroneous device can also be used to exchange, repair, or at least monitor the respective device or transmission line in the physical technical system 10, e.g. the electrical power grid. The graph neural network unit can preferably be configured as a graph convolutional neural network.

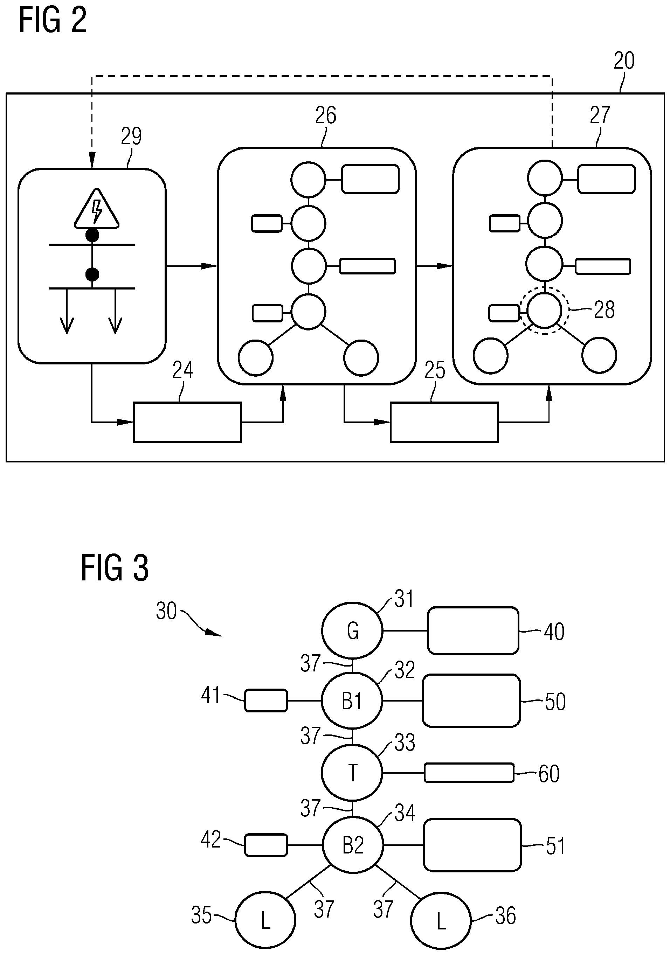

Figure 2 illustrates the main steps of the data processing in the assistance apparatus 20. It comprises an end-to-end procedure for training and inference of the assistance apparatus 20.

Data 29 of the technical system 10 consists of actual attributes of the devices and transmission line 11, 12, 13 and are associated to the devices and transmission lines 11, 12, 13. Dynamic attributes consisting of sensor data of a set of parameters measured at the device or transmission lines 11, 12, 13. Static attributes can also be node features, e.g. the length of a transmission line or impedance of a transmission line or maximum power of a generator. The obtained actual attributes can also be restricted to devices and transmission lines a sub-zone of the technical system 10 and its respective attributes can be input and processed by the assistance apparatus 20.

Data 29 of the technical system 10 is transformed by the graph representation converter 24 into an attributed graph representation 26 of the technical system 10. In a learning phase, the attributed graph representation 26 of the technical system 10 or of a similar technical system, is used to train the graph neural network. Characteristics of the attributed graph representation used for training are described below in more detail.

In an inference phase, the graph neural network unit 25 processes the graph representation 26 by the trained graph neural network and outputs an indication 28, e.g. in the graph representation 27 of such devices and/or transmission lines 11, 12, 13 whose error probability is higher than a predefined threshold.

Figure 3 shows an example graph representation of a technical system, here a power grid consisting of a generator, a first and a second bus bar, and a transmission line. The graph representation 30 is structured such that it represents the topology of the technical system. Each device or transmission line, here the generator G, the two bus bars B1, B2 as well as the transmission line T, are represented each by a node 31, 32, 33, 34. Each pair of nodes which interact with each other is connected by an edge 37. In the graph representation 30 different types of nodes are represented by a capital letter, e.g. an node representing a generator is indicated by a "G", the node type for a bus is indicated by a "B", the node type for a transmission line is indicated by a "T", and a node type representing a load 35, 36 in the power grid is represented by a "L". The obtained values of attributes of the devices are assigned to each of the nodes 31, 32, 33, 34. For example the value of a measured voltage magnitude 40 is assigned to the generator, see node 32. The power and quality 42 as measured at the bus bar B1 is assigned to node 32, measured values for power and quality 42 measured for bus bar B2 indicated by node 34. The impedance 60 of the transmission line T is assigned to node 33. Voltage and phase angle 50, 51 of bus bar B1 and bus bar B2 are unknown.

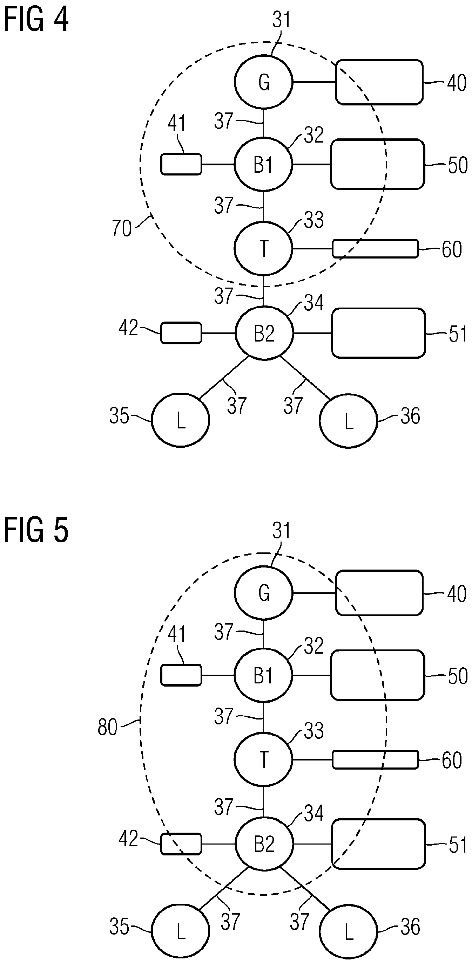

The message forwarding for a one-layer graphic convolutional network is shown in figure 4. The vector representations h are determined for node 31 representing a generator, node 32 representing a bus bar, and node 33 representing a transmission line by the graph neural network.

The vector representation h for each node determined by the graph neural network, especially as determined by a graph convolutional neural network, are following:

$$h^1_{gen} = \sigma\left(Agg\left(W^1 x_{gen}, W^1 x_{bus1}\right)\right)$$

$$h^1_{bus1} = \sigma\left(Agg\big(W^1 x_{bus1}, W^1 x_{gen}, W^1 x_{line}\big)\right)$$

$$h^1_{line} = \sigma\big(Agg(W^1 x_{line}, W^1 x_{bus2}, W^1 x_{bus1})\big)$$

Each node is represented by a vector representing the assigned attributes as follows:

$$x_{bus} = [p, q, i]$$

$$x_{line} = [impedance, length]$$

$$x_{generator} = [v, \theta, p, q, i]$$

$$x_{load} = [v, \theta, p, q, i]$$

wherein the attributes represent active power $p$, reactive power $q$, current $i$, frequency $v$, phase angle $\theta$ as well as the impedance and the length as static features of a transmission line. The vector representation h for each node comprises of a non-linear activation function $\sigma$, e.g. a sigmoid function or a ReLU-function, applied on an aggregation function *Agg*, typically a sum of a maximum or a mean value applied on weight matrices *W* of the graph neural network.

Node 32 is indicated, see dash line 70, being erroneous or deviating in one of the attributes from the predicted value with a probability higher than a predefined threshold.

The graph convolution of the two-layer graph convolution neural network is shown in figure 5. A further vector representation is generated for node 34 representing a second bus bar. All vector representations generated by the two-layer graph convolutional neural network are as follows:

$$h^1_{gen} = \sigma\left(Agg\big(W^1 x_{gen}, W^1 x_{bus1}\big)\right)$$

$$h^1_{bus1} = \sigma\left(Agg\big(W^1 x_{bus1}, W^1 x_{gen}, W^1 x_{line}\big)\right)$$

$$h^1_{line} = \sigma\big(Agg(W^1 x_{line}, W^1 x_{bus2}, W^1 x_{bus1})\big)$$

$$h^2_{bus1} = \sigma\big(W^2 h^1_{bus1}, W^2 h^1_{gen}, W^2 h^1_{line}\big)$$

Based on the vector representations an error probability given by

$$error = \big\|[v_1, \theta_1] \text{-} W^3 h^2_{bus1}\big\|^2$$

is minimized. As a result, a predicted value for an attribute, e.g. a voltage magnitude and a phase angle are calculated. In summary the technical system 10 is converted to an attributed heterogeneous graph representation 26. Then a graph neural network 27 infers nodes which contain bad attributes, either bad measurements or a bad node feature.

When applying a one-layer graph neural network actual values of attributes of at least the direct neighbours are required as input and a vector representation for a node is at least passed to the nearest neighbour, whereas for a two-layer graph neural network, vector representations of a node are propagated to at least the subsequent neighbours. Accordingly, actual values of attributes obtained in the assistance apparatus are required for the respective nodes to which vector representations are propagated. Accordingly, the graph representation in Figure 4 provides an indication 70 of erroneous node 32 taking into account all the direct neighbouring nodes 31 and 33. Accordingly, the graph representation in Figure 5 provides an indication 80 of erroneous node 32 taking into account all the direct neighbouring nodes 31, 33 and all direct neighbours 34 of the neighbouring nodes 31, 33.

The attributed graph representation used for training the graph neural network comprises training attributes for each node of the technical system 10. In comparison to that if an already trained graph neural network is used to localize an error an attributed graph representation comprising the actual attributes of the technical system can comprise attributes for only a sub-set of nodes of the technical system 10.

Two training regimes can be applied to train the graph neural network of the graph neural network unit 25. A node classification can be performed as a first training regime. This means that the graph neural network is trained to identify nodes with errors as a binary classification problem such that "0" indicates no error and "1" indicates an error. A second training regime uses node regression. In this case the graph neural network of graph neural network unit 25 is trained to predict a state estimation value of a node as a regression problem.

For the node classification training regime, the graph neural network is trained by the attributed graph representation comprising training attributes of at least one node operating in an abnormal mode. In a preferred embodiment the graph neural network is trained by injecting attributes representing erroneous measurements or erroneous node features of one or few nodes at a predetermined location into the graph representation wherein the attributes of all other nodes represent error-free measurements or node features.

Most preferred the erroneous measurement is set to a measurement value of reverse algebraic sign with respect to the error-free measurement value of the attribute of the node. In other words, erroneous measurements are injected into a predetermined node of the graph neural network to train the graph neural network to detect the location of the error. By flipping the sign of the attribute, i.e. measurement or feature of the node, a well-defined error type is presented to the graph neural network. In result, the graph neural network can predict with high probability the node having a erroneous attribute. The graph neural network provides as an output a probability for the nodes either having an error or having no error.

In contrast to other neural networks, graph neural networks can generalize across different topologies, e.g., power grids of different topologies. This is due to their flexibility of vector passing through nodes of any network. This training regime is particularly advantageous because an abundance of training data can be generated from each error-free power grid. If the performance of the graph neural network is insufficient, additional training data can be generated by conceiving new perturbation mechanisms that introduce additional error types.

In the second training regime, i.e. node regression, the graph neural network is trained by attributed graph representations comprising training attributes representing all nodes operating in a normal mode. Normal mode means here that it is assumed that the attributes are correct, i.e. error-free. The graph neural network is then trained by minimising a loss function between the values of the trained attributes and predicted values of the training attributes of each node, especially by minimising a mean squared error function. This means that a weight matrix of the graph neural network is determined by this loss function. Once the training is completed the trained graph neural network is used to predict the value of the attributes of each node.

In the inference phase, the predicted values of the attributes are compared to the value of obtained actual attributes. If the predicted and the obtained values of the attribute deviate significantly this is evidence of an error. In this case the trained graph neural network provides as an output predicted values of the attributes of each node.

When the assistance apparatus 20 is used to localize errors in an electrical power grid the different types of nodes of the graph representation provide different types of devices, for example power generation devices, power switching devices, power connecting or concentration devices like a bus bar or a power transmission line. The edges between two nodes in a respective graph representation represent a potential flow of current.

All localized properties of the graph neural network are beneficial in this case. Since the influencing area of a predicted value is only the local neighbourhood of that node, the search space for an error is also restricted to this local neighbourhood.

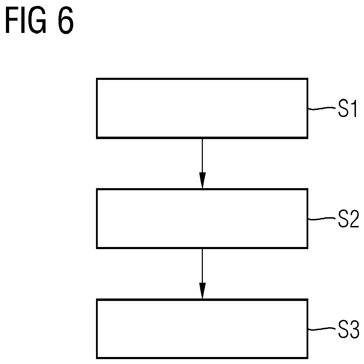

Figure 6 shows a flow chart representing the respective method for localizing errors in a monitored technical system 10 of interconnected devices. As a first step S1 values of actual attributes of the devices and/or transmission lines are obtained. In a second step S2 an error probability for each device and/or transmission line is determined by processing a graph neural network with the obtained actual values of attributes as input, wherein in the graph neural network is trained by training attributes assigned to an attributed graph representation of the technical system. In the last step S3 an indication is output for such devices and/or transmission lines whose error probability is higher than a predefined threshold.

Such the assistance apparatus and the respective method localizes errors in the data of a power grid used for example to generate a distribution system state estimation. Pointing to a location in the underlying power grid allows an operator of the power grid to investigate and resolve errors more quickly either in the calculation of the distribution system state estimation or in the real physical power grid.

It is to be understood that the above description of examples is intended to be illustrative and that the illustrated components are susceptible to various modifications. For example, the illustrated concepts could be applied for different technical systems and especially for different subtypes of the respective technical system with only minor adaptions.

**Claims**

1. Assistance apparatus for localizing errors in a monitored technical system (10) consisting of devices and/or transmission lines, comprising at least one processor configured to

    - obtain values of actual attributes of the devices (11, 12) and/or of the transmission lines (13),
    - determine an error probability for each device (11, 12) and/or transmission line (13) by processing a graph neural network with the obtained actual values of attributes as input, wherein the graph neural network is trained by training attributes assigned to an attributed graph representation (26) of the technical system (10), and
    - output an indication for such devices (11, 12) and/or transmission lines (13), whose error probability is higher than a predefined threshold.

2. Assistance apparatus according to claim 1, wherein the attributed graph representation (26) represents the topology of the technical system (10), wherein each device (11, 12) and each transmission line (13) is represented by one node (31,..,34), and each pair of nodes (31,..,36) interacting with each other is connected by an edge (37), and wherein different types of devices (11, 12) and types of transmission lines (13) are represent by different types of nodes (31,..,36) .

3. Assistance apparatus according to any of the preceding claims, wherein the attributes assigned to the node (31,..,36) comprise at least one of sensor data of a set of parameters measured at the node and static features of the node (31, ..,36) .

4. Assistance apparatus according to any of the preceding claims, wherein the graph neural network determines a vector representation of each node (31,..,36) and forwards the determined vector representation of the node to the neighbouring nodes (31,..,36).

5. Assistance apparatus according to any of the preceding claims, wherein the graph neural network is trained by the attributed graph representations (26) comprising training attributes of at least one node (31,..,36) operating in an abnormal mode.

6. Assistance apparatus according to claim 5, wherein the graph neural network is trained by injecting attributes representing erroneous measurements of a predetermined node into the attributed graph representation (26), wherein the attributes of all other nodes represent error-free measurements.

7. Assistance apparatus according to claims 6, wherein the injected attribute representing erroneous measurements is a measurement value of reverse algebraic sign with respect to an error-free measurement value of the attribute of the node (31,..,36).

8. Assistance apparatus according to claims 5 or 7, wherein the trained graph neural network provides as an output a probability for the nodes (31,..,36) either having an error or having no error.

9. Assistance apparatus according to any of the preceding claims 1 to 4, wherein the graph neural network is trained by attributed graph representations (26) comprising training attributes of the nodes (31,..,36) representing all nodes (31,..,36) operating in a normal mode.

10. Assistance apparatus according to claims 8 or 9, wherein the trained graph neural network provides as an output predicted values of the attributes of each node (31,..,36).

11. Assistance apparatus according to claims 9 or 10, wherein the graph neural network is trained by minimizing a loss function between the values of the training attributes and predicted values of the training attributes of each node (31,..,36), especially by minimizing a mean squared error function.

12. Assistance apparatus according to any of the preceding claims, wherein the technical system (10) is a technical distribution network, especially an electrical power grid.

**13.** Assistance apparatus according to claim 12, wherein different types of nodes (31,..,36) of the graph representation represent different types of power generation devices, power switching devices and/or power transmission lines and the edge (37) between two nodes (31,..,36) represents a potential flow of current.

**14.** Method for localizing errors in a monitored technical system (10) consisting of devices (11, 12) and/or transmission lines (13), comprising

- obtaining (S1) values of actual attributes of the devices (11, 12) and/or of the transmission lines (13),
- determining (S2) an error probability for each device (11, 12) and/or transmission line (13) by processing a graph neural network with the obtained actual values of attributes as input, wherein the graph neural network is trained by training attributes assigned to an attributed graph representation (26) of the technical system (10), and
- outputting (S3) an indication for such devices (11, 12) and/or transmission lines (13), whose error probability is higher than a predefined threshold.

**15.** A computer program product directly loadable into the internal memory of a digital computer, comprising software code portions for performing the steps of claim 14 when said product is run on said digital computer.

FIG 1

FIG 2

FIG 3

FIG 4

FIG 5

## FIG 6

Europäisches
Patentamt

European
Patent Office

Office européen
des brevets

# EUROPEAN SEARCH REPORT

Application Number

EP 20 21 1327

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KHORASGANI HAMED ET AL: "Fault Detection and Isolation in Industrial Networks using Graph Convolutional Neural Networks", 2019 IEEE INTERNATIONAL CONFERENCE ON PROGNOSTICS AND HEALTH MANAGEMENT (ICPHM), IEEE, 17 June 2019 (2019-06-17), pages 1-7, XP033609186, DOI: 10.1109/ICPHM.2019.8819403 [retrieved on 2019-08-28] * figure 2 * * Section I- Section IV * | 1-15 | INV. H02J3/00 G06N3/02 H02J13/00 |
| A | US 2020/292608 A1 (YAN WEIZHONG [US] ET AL) 17 September 2020 (2020-09-17) * figures 1,2,4 * * paragraph [0005] - paragraph [0007] * | 1-15 | |
| A | YUXIAO LIU ET AL: "Guiding Cascading Failure Search with Interpretable Graph Convolutional Network", ARXIV.ORG, CORNELL UNIVERSITY LIBRARY, 201 OLIN LIBRARY CORNELL UNIVERSITY ITHACA, NY 14853, 30 January 2020 (2020-01-30), XP081589391, * figures 1,6 * * Section II * | 1,14,15 | TECHNICAL FIELDS SEARCHED (IPC) H02J G06N |
| A | WO 2019/036095 A1 (SIEMENS AG [DE]) 21 February 2019 (2019-02-21) * figure 5 * | 1,14,15 | |

The present search report has been drawn up for all claims

| Place of search | Date of completion of the search | Examiner |
|---|---|---|
| Munich | 29 April 2021 | Despis, Enguerran |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 20 21 1327

This annex lists the patent family members relating to the patent documents cited in  the above-mentioned European search report.
The members are as contained in the European Patent Office EDP file on
The European Patent Office is in no way liable for these particulars which are merely given for the purpose of information.

29-04-2021

| Patent document cited in search report | | Publication date | Patent family member(s) | | Publication date |
|---|---|---|---|---|---|
| US 2020292608 | A1 | 17-09-2020 | US 2020292608 A1<br>US 2020293032 A1<br>US 2020293033 A1 | | 17-09-2020<br>17-09-2020<br>17-09-2020 |
| WO 2019036095 | A1 | 21-02-2019 | EP 3655900 A1<br>US 2020218973 A1<br>WO 2019036095 A1 | | 27-05-2020<br>09-07-2020<br>21-02-2019 |

EPO FORM P0459

For more details about this annex : see Official Journal of the European Patent Office, No. 12/82